(19) Europäisches Patentamt
European Patent Office
Office européen des brevets

(11) Numéro de publication : **0 176 130 B1**

# (12) FASCICULE DE BREVET EUROPÉEN

(45) Date de publication du fascicule du brevet : **27.07.88**

(51) Int. Cl.⁴ : **C 30 B 15/00**, C 30 B 29/40, C 30 B 29/42

(21) Numéro de dépôt : **85201421.6**

(22) Date de dépôt : **10.09.85**

## (54) Procédé de réalisation d'un monocristal d'arséniure de gallium et d'indium.

(30) Priorité : **14.09.84 FR 8414142**

(43) Date de publication de la demande : **02.04.86 Bulletin 86/14**

(45) Mention de la délivrance du brevet : **27.07.88 Bulletin 88/30**

(84) Etats contractants désignés : **DE FR GB NL**

(56) Documents cités :
**GB-A- 1 429 158**
**JOURNAL OF CRYSTAL GROWTH, vol. 61, 1983, pages 417-424, North-Holland Publishing Co., NL; G. JACOB et al.: "Dislocation-free GaAs and InP crystals by isoelectronic doping"**
**JOURNAL OF CRYSTAL GROWTH, vol. 18, 1973, pages 202-204, North-Holland Publishing Co., NL; F. CERRINA et al.: "Growth of GaAs1-xPx crystals by pulling from gallium-rich solutions"**

(73) Titulaire : **Laboratoires d'Electronique et de Physique Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB NL**

(72) Inventeur : **Duseaux, Marc Pierre Société Civile S.P.I.D.**
**209 rue de l'Université**
**F-75007 Paris (FR)**
Inventeur : **Martin, Sylvie Alice Société Civile S.P.I.D.**
**209 rue de l'Université**
**F-75007 Paris (FR)**

(74) Mandataire : **Landousy, Christian et al**
**Société Civile S.P.I.D. 209, Rue de l'Université**
**F-75007 Paris (FR)**

**EP 0 176 130 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

L'invention concerne un procédé de réalisation d'un monocristal d'arséniure de gallium (GaAs), de type semi-isolant, incluant l'élément indium (In) pour diminuer les dislocations.

L'invention trouve son application dans la réalisation de substrats semi-isolants pour dispositifs semi-conducteurs dans les cas où une forte densité d'intégration et de hautes performances sont requises.

Un procédé de réalisation d'un tel monocristal est connu de l'art antérieur par le brevet britannique GB-PS.1242 410 publié le 11 août 1971, déposé par la Demanderesse.

Ce procédé consiste en la croissance de couches monocristallines d'arséniure de gallium à partir d'une solution en phase liquide dans laquelle de l'indium est incorporé en quantité inférieure à 5 %, de manière à ce que, du fait du faible coefficient de ségrégation de l'indium, la quantité d'indium dans le monocristal terminé soit négligeable (inférieure à 0,5 %), l'indium ne s'intégrant alors pas dans le réseau cristallin.

Selon le document cité, dans ces conditions, les qualités cristallines des couches d'arséniure de gallium sont grandement améliorées. Ce document enseigne en outre que le monocristal peut être dopé à l'aide d'impuretés afin d'obtenir des propriétés électriques spécifiques.

Mais la méthode préconisée, qui est celle de l'épitaxie en phase liquide, ne permet pas l'obtention de très gros monocristaux. De plus, les impuretés telles que le chrome qui doivent être incluses dans le bain pour réaliser un cristal présentant par exemple des propriétés semi-isolantes, possèdent un coefficient de ségrégation très petit. De ce fait, elles ne s'incorporent pas uniformément dans le cristal. De plus, elles ont tendance à diffuser de façon inopportune dans les couches épitaxiales qui peuvent être réalisées par la suite sur ce cristal utilisé comme substrat.

Le problème technologique posé est donc double :

— obtention d'un gros monocristal sans dislocations.

— obtention d'un tel monocristal du type semi-isolant sans adjonction de dopants gênants.

C'est pourquoi la présente invention propose un procédé de réalisation d'un monocristal d'arséniure de gallium caractérisé en ce que ce monocristal est formé à partir d'un bain fondu dans lequel la concentration en arsenic (As) par rapport à la masse totale d'arsenic plus gallium (Ga + As) est supérieure à 45 % et inférieure à 51 %, en ce que la concentration de l'élément indium (In), introduit sous la forme d'arséniure d'indium (InAs), par rapport à la masse d'arsenic plus gallium (Ga + As) est supérieure à 5 % et inférieure à 10 %, de telle sorte que le monocristal obtenu à partir de ce bain fondu est de tendance p, et que la concentration de l'élément indium dans le monocristal, lequel présente la formule $Ga_{1-x}In_xAl$, est x = 1 %, et caractérisé en ce que ce monocristal de tendance p est ensuite soumis à un recuit pour augmenter le niveau des donneurs profonds $EL_2$ jusqu'à une valeur telle que le monocristal présente alors les propriétés d'un semi-isolant.

L'avantage du procédé proposé par la présente invention est donc de fournir un monocristal qui est à la fois :

— compatible avec les technologies des circuits intégrés sur arséniure de gallium (GaAs) ;

— compatible avec la croissance épitaxiale de nombreux composés du groupe III-V ;

— dépourvu de dislocations du réseau cristallin (moins de 500 au $cm^3$) ;

— de grande dimension ;

— semi-isolant ;

— dépourvu de dopants gênants ;

— doté de propriétés électriques homogènes.

L'invention sera mieux comprise grâce à la description suivante illustrée par :

— les figures 1 montrant en coupe la répartition du défaut EL2 dans un cristal d'arséniure de gallium dopé à l'indium ($Ga_{1-x}In_xAs$), la figure la montrant cette répartition avant recuit dans une coupe perpendiculaire à l'axe de tirage, la figure 1b montrant cette répartition avant recuit dans une coupe parallèle à l'axe de tirage, la figure 1c montrant cette répartition après recuit dans une coupe perpendiculaire à l'axe de tirage et la figure 1d montrant cette répartition après recuit dans une coupe parallèle à l'axe de tirage.

Selon la présente invention, l'obtention d'un gros monocristal dépourvu de dislocations est résolu dans un premier temps par le tirage à partir d'un bain fondu par la méthode Czochralski sous encapsulation liquide d'un monocristal d'arséniure de gallium dopé à l'aide d'un élément iso-électronique tel que l'indium dans les proportions de $10^{19}$ à $2.10^{20}$ atomes par $cm^3$.

Un tel monocristal présente comme formule générale :

$$Ga_{1-x}In_xAs$$

dans laquelle la concentration x est de l'ordre de 1 %.

Il est clair que les conditions de tirage par la méthode Czochralski, permettent certes l'obtention de monocristaux de grandes tailles mais créent des difficultés telles que par exemple les tensions dans le cristal, qui ne peuvent être surmontées qu'en définissant de façon spécifique les différents paramètres du tirage.

C'est pourquoi en particulier la concentration x en indium se trouve être beaucoup plus importante que la concentration préconisée par l'art antérieur.

On a donc par un procédé de tirage approprié et par dopage à l'indium convenable, résolu le problème de la qualité cristalline du matériau que l'on désire utiliser comme substrat de circuits intégrés.

Mais l'on doit alors résoudre le second problème qui consiste à réaliser un tel cristal avec les propriétés d'un semi-isolant.

Or les propriétés électriques de l'arséniure de gallium sont données par la combinaison des centres actifs présents dans le matériau et en particulier par leurs concentration respectives et leur niveau énergétique dans la bande interdite.

Cette combinaison permet de déterminer le niveau de Fermi. Si ce niveau est près de la bande de conduction, le cristal est de type n, si ce niveau est près de la bande de valence, le cristal est de type p. Si le niveau est bloqué au milieu de la bande interdite, le cristal est semi-isolant et possède une forte résistivité.

Les centres actifs peuvent être de deux types :

— des impuretés (résiduelles ou introduites volontairement),

— des défauts natifs, dont EL2 qui présente une énergie située à peu près au milieu de la bande interdite, pour l'arséniure de gallium.

Le type électrique des cristaux d'arséniure de gallium non dopés dépend donc d'abord de la stoechiométrie du bain de tirage lors de leur élaboration. Si le bain est riche en gallium alors le cristal est de tendance p et présente un excès d'accepteurs. Si au contraire le bain est riche en arsenic alors le cristal est de tendance n et présente un excès de donneurs.

Dans ces conditions, pour obtenir un cristal semi-isolant selon la présente invention, on part d'un cristal de tendance p dans lequel on fait apparaître une quantité appropriée de donneurs profonds.

Cette approche est différente de celle de l'art antérieur qui préconisait de partir de couches monocristallines à tendance n et d'y introduire des impuretés à rôle d'accepteurs, telles que le chrome. Mais cette solution présente comme on l'a vu de nombreux inconvénients et doit être écartée.

L'approche choisie dans la présente invention est d'autant plus originale et la solution trouvée plus étonnante que des impuretés capables de jouer le rôle de donneurs profonds n'existent pas dans l'état actuel de la technique.

Or, comme il est montré sur les figures 1a et 1b on a pu constater qu'un cristal d'arséniure de gallium et d'indium réalisé selon l'invention brut de tirage présente un niveau de concentration des défauts EL2 qui est à la fois :

— très homogène

et

— très faible, de l'ordre de 3 à $5.10^{15}$ $cm^{-3}$.

Le tableau I donne les concentrations en défauts EL2 des différentes zones de ce cristal pour une meilleure compréhension des figures

Tableau I

| Repère numérique des zones | Concentration en défauts EL2 |
|---|---|
| 1 | 3 à 4,9 . $10^{15}$ . $cm^{-3}$ |
| 2 | 5 à 6,9 . $10^{15}$ . $cm^{-3}$ |
| 3 | 7 à 9,9 . $10^{15}$ . $cm^{-3}$ |
| 4 | 10 à 12,4 . $10^{15}$ . $cm^{-3}$ |
| 5 | 12,5 à 15 . $10^{15}$ . $cm^{-3}$ |

Le comportement du défaut EL2 dans l'arséniure de gallium est connu par la publication de D. Rumsby et alii dans GaAs IC Symposium, 1983 IEEE, intitulée « Improved uniformity of L.E.C. undoped Gallium Arsenide produced by high temperature annealing ».

Le document cité enseigne qu'une solution existe pour rendre homogènes les propriétés électriques d'un monocristal d'arséniure de gallium non dopé. Il s'agit d'un recuit de ce cristal à une température de 950 °C pendant au moins 5 heures. Ce recuit produit un nivellement des valeurs des concentrations de défauts EL2.

Donc si le document cité enseigne le moyen d'obtenir des propriétés électriques homogènes et en particulier un niveau de concentration des défauts EL2 constant dans un cristal d'arséniure de gallium non dopé, il n'apprend rien sur le comportement du niveau de défauts EL2 dans un cristal d'arséniure de gallium et d'indium, ni sur une méthode pour obtenir un tel cristal semi-isolant sans inclure de dopants gênants.

Selon la présente invention, ce dernier problème est résolu en réalisant tout d'abord un monocristal d'arséniure de gallium et d'indium par la méthode décrite précédemment, à partir d'un bain fondu riche

en gallium, de manière telle que le monocristal obtenu est de tendance p, puis en soumettant ce monocristal à un simple recuit.

En effet, par cette opération, le cristal d'arséniure de gallium dopé à l'indium qui présentait à l'issu du tirage un faible niveau de défauts EL2 comme montré sur les figures 1a et 1b, voit ce niveau monter de façon étonnante par l'effet du recuit comme il est montré sur les figures 1c et 1d, tout en restant uniforme.

Ce résultat est d'autant plus étonnant que, si l'art antérieur nous enseignait à obtenir l'uniformité du niveau des défauts EL2 dans un cristal de composition proche, il ne nous enseignait pas à en changer considérablement la valeur. Du fait que, dans un cristal selon l'invention, l'uniformité du défaut EL2 était obtenue dès l'origine, il n'était pas tentant d'essayer un recuit pour trouver une solution au problème. L'effet étonnant tient donc dans l'augmentation de la concentration du défaut $EL_2$ par recuit.

Cependant, après le recuit, la concentration en donneurs profonds dans le monocristal d'arséniure de gallium et d'indium, est devenue suffisante pour que ce monocristal soit semi-isolant. L'adjonction d'impuretés gênantes telles que le chrome est donc évitée.

Il y a tout lieu de penser que le niveau de défauts EL2 est lié à un défaut intrinsèque du cristal qui pourraît être le placement d'atomes d'arsenic sur les sites gallium (antisites). Les résultats obtenus par la mise en œuvre de la présente invention suggèrent que, contrairement à ce qui était admis auparavant, l'homogénéisation des défauts EL2 lors d'un recuit d'arséniure de gallium non dopé n'est pas due à la diffusion de défauts existant dans le matériau, mais au contraire à l'évolution vers un équilibre thermodynamique. Ce serait à l'évolution vers un tel équilibre thermodynamique que l'on devrait alors l'augmentation du niveau de défauts EL2 dans l'arséniure de gallium dopé à l'indium lors du recuit.

Ce résultat a priori inattendu permet donc d'obtenir, à partir de cristaux d'arséniure de gallium dopés à l'indium réalisés selon l'invention, des substrats semi-isolants qui présentent de gros avantages du fait qu'ils sont dépourvus à la fois de dislocations et de dopants gênants. Ces substrats permettent de réaliser à leur surface des couches épitaxiales aussi parfaites que possible, et des éléments de circuits miniaturisés dont les propriétés sont répétitives.

Une mise en œuvre de ce procédé de réalisation peut être menée à bien de la façon suivante. Le cristal d'arséniure de gallium dopé à l'indium est réalisé par la méthode de tirage Czochralski sous encapsulation liquide, dans un creuset en quartz ou bien en polynitrure de bore (PNB). Le bain est riche en gallium, ce qui s'exprime par le fait que la concentration de la masse de gallium par rapport à la masse d'arsenic plus gallium dans le bain fondu est supérieure à 49 %, ou bien encore par le fait que la concentration de la masse d'arsenic par rapport à la masse d'arsenic plus gallium dans le bain fondu est comprise entre 45 et 51 %. Le dopage à l'indium peut être fait en introduisant dans le bain une quantité d'arséniure d'indium définie par le rapport de la masse $m_{InAs}$ de l'arséniure d'indium à la masse $m_{GaAs}$ de l'arséniure de gallium

$$5 \leqslant m_{InAs}/m_{GaAs} \leqslant 10\ \%$$

ce qui est obtenu par exemple pour des masse de :

550 g d'arsenic (As) associés à

510 g de gallium (Ga) et à

70 g d'arséniure d'indium (InAs) dans le bain fondu.

La vitesse de tirage est faible, par exemple inférieure à 15 mm à l'heure. La formule générale du cristal obtenu est :

$$Ga_{1-x}IN_xAs$$

dans laquelle la concentration $x \simeq 1\ \%$ ce qui est très différent de l'art antérieur.

Une température de recuit convenable est comprise entre 800 °C et 1 000 °C, par exemple de l'ordre de 900 °C. Ce recuit doit être effectué pendant au moins 1 heure.

Avant le recuit, le niveau des défauts EL2 est compris entre 3 et $5.10^{15}$ $cm^{-3}$ (figure 1a et 1b). Après le recuit ce niveau est supérieur à $12.10^{15}$ $cm^{-3}$ comme il est illustré par les figures 1c et 1d.

**Revendications**

1. Procédé de réalisation pour obtenir un monocristal d'arséniure de gallium (GaAs), de type semi-isolant, incluant l'élément indium (In) pour diminuer les dislocations, caractérisé en ce que ce monocristal est formé à partir d'un bain fondu dans lequel la concentration en arsenic (As) par rapport à la masse totale d'arsenic plus gallium (Ga + As) est supérieure à 45 % et inférieure à 51 %, en ce que la concentration de l'élément indium (In), introduit sous la forme d'arséniure d'indium (InAs), par rapport à la masse d'arsenic plus gallium (Ga + As) est supérieure à 5 % et inférieure à 10 %, de telle sorte que le monocristal obtenu à partir de ce bain fondu est de tendance p, et que la concentration de l'élément indium dans le monocristal, lequel présente la formule $Ga_{1-x}In_xAl$, est $x \simeq 1\ \%$, et caractérisé en ce que ce monocristal de tendance p est ensuite soumis à un recuit pour augmenter le niveau des donneurs profonds $EL_2$ jusqu'à une valeur telle que le monocristal présente alors les propriétés d'un semi-isolant.

2. Procédé de réalisation selon la revendication 1, caractérisé en ce que le monocristal d'arséniure de gallium et d'indium de tendance p est obtenu à partir du bain fondu par la méthode Czochralski de tirage sous encapsulation liquide, avec une vitesse de tirage inférieure ou égale à 15 mm à l'heure.

3. Procédé de réalisation selon la revendication 2, caractérisé en ce que le recuit auquel est soumis le monocristal à tendance p pour le rendre semi-isolant est pratiqué à une température comprise entre 800 °C et 1 000 °C pendant au moins une heure à la suite duquel les donneurs profonds $EL_2$ dans le monocristal atteignent un niveau supérieur à $12.10^{15}$ par $cm^3$.

**Claims**

1. A method of manufacturing a single crystal of gallium arsenide (GaAs) of the semi-insulating type, including the element indium (In) to reduce the dislocations, characterized in that this single crystal is formed from a molten bath, in which the concentration of arsenic (As) with respect to the total mass of arsenic plus gallium (Ga + As) is higher than 45 % and lower than 51 %, in that the concentration of the element indium (In) introduced in the form of indium arsenide (InAs) with respect to the mass of arsenic plus gallium (Ga + As) is higher than 5 % and lower than 10 % in such a manner that the single crystal obtained from this molten bath is of the p -type and the concentration of the element indium in the single crystal, which has the formula $Ga_{1-x}+In_x+As$, is $x \simeq 1$ %, and characterized in that this single crystal of the p -type is then subjected to an annealing operation to increase the level of the deep donors $EL_2$ to such a value that the single crystal then has the properties of a semi-insulator.

2. A method of manufacturing as claimed in Claim 1, characterized in that the single crystal of gallium indium arsenide of the p -type is obtained from the molten bath by the Czochralski pulling method with liquid encapsulation with a pulling rate less than or equal to 15 mm per hour.

3. A method of manufacturing as claimed in Claim 2, characterized in that the annealing operation to which the single crystal of the p -type is subjected to render it semi-insulating is carried out at a temperature lying between 800 °C and 1 000 °C during at least one hour, after which the deep donors $EL_2$ in the single crystal reach a level higher than $12.10^{15}$ per $cm^3$.

**Patentansprüche**

1. Verfahren zum Erhalten eines Einkristalls von Galliumindiumarsenid (GaAs) vom Halbleitertyp mit dem Element Indium (In) zum Verringern der Versetzungen, dadurch gekennzeichnet, dass der Einkristall dadurch gebildet wird, dass ausgegangen wird von einem Schmelzbad, in dem die Arsenkonzentration (As) gegenüber der gesamten Arsen-Gallium-Masse (Ga + As) mehr als 45 % und weniger als 51 % ist und dass die Konzentration des Elementes Indium (In), das in Form von Indiumarsenid (InAs) eingeführt worden ist, gegenüber der Arsen-Gallium-Masse (Ga + As) mehr als 5 % und weniger als 10 % ist und zwar derart, dass der erhaltene Einkristall, ausgehend von diesem Schmelzbad p-leitend ist und dass die Konzentration des Elementes Indium in dem Einkristall, der durch die folgende Formel ausgedrückt wird, $Ga_{1-x}In_xAl_x = 1$ % beträgt, und dadurch gekennzeichnet, dass dieser p-leitende Einkristall danach einer Glühbehandlung ausgesetzt wird und zwar zum Erhöhen des Pegels der tiefen Donatoren $EL_2$ auf einen derartigen Wert, dass der Einkristall die Eigenschaften eines Halbisolierers aufweist.

2. Verfahren nach Anspruch 1, dadurch gekennzeichnet, dass der p-leitende Einkristall von Galliumindiumarsenid nach dem Czochralski-Verfahren unter flüssiger Einkapselung aus einem Schmelzbad gezogen wird und zwar mit einer Ziehgeschwindigkeit, die weniger als oder gleich 15 mm/Stunde beträgt.

3. Verfahren nach Anspruch 2, dadurch gekennzeichnet, dass das Ausglühen, dem der p-leitende Einkristall um ihn halbisolierend zu halten ausgesetzt wird, bei einer Temperatur zwischen 800 °C und 1 000 °C erfolgt und zwar während mindestens einer Stunde, wonach die tiefen Donatoren $El_2$ in dem Einkristall einen Pegel über $12.10^{15}/cm^3$ erreichen.

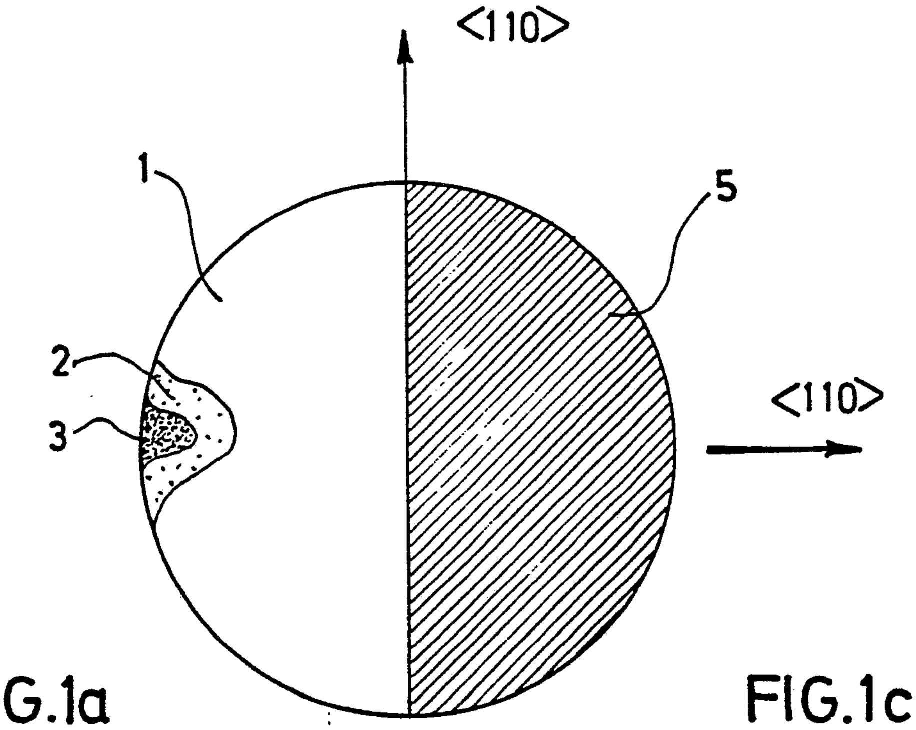


FIG.1a FIG.1c

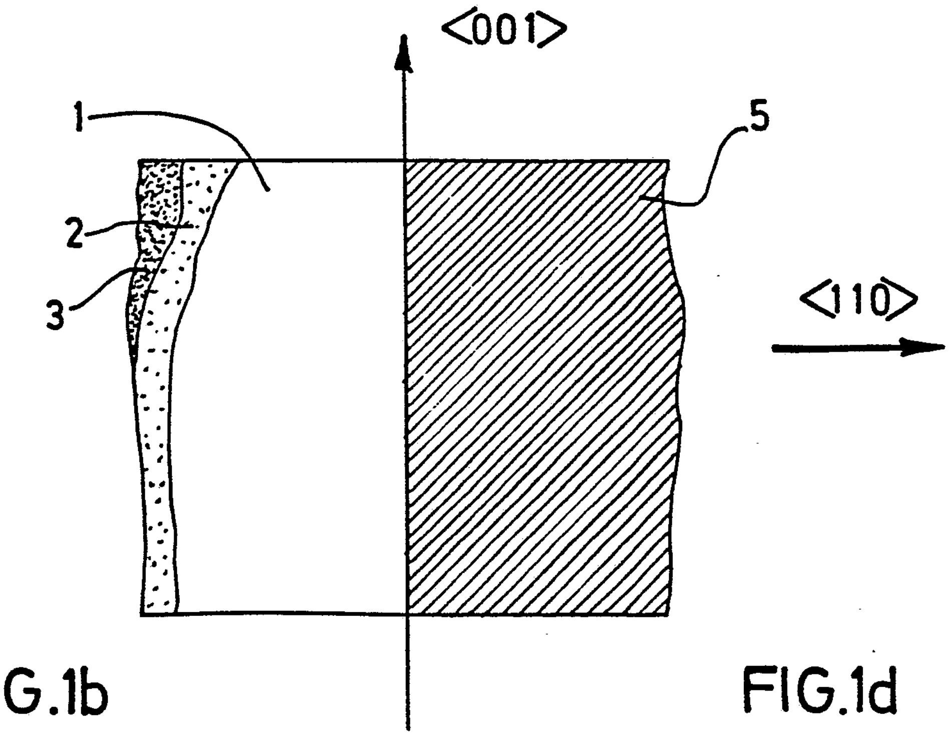


FIG.1b FIG.1d